# EUROPEAN PATENT SPECIFICATION

(11) **EP 1 029 373 B1**
(45) Date of publication and mention of the grant of the patent: **11.04.2012**
(21) Application number: 98955237.7
(22) Date of filing: 02.11.1998
(51) Int. Cl.: H01L 41/08, F23Q 2/28

(54) **SELECTIVELY ACTUATABLE PIEZOELECTRIC IGNITION MECHANISM**
SELEKTIV BETÄTIGBARER PIEZOELEKTRISCHER ZÜNDMECHANISMUS
MECANISME D'ALLUMAGE PIEZO-ELECTRIQUE A ACTIONNEMENT SELECTIF

(30) Priority: 03.11.1997 US 962672
(43) Date of publication of application: 23.08.2000
(73) Proprietor: BIC CORPORATION, Milford CT 06460 (US)
(72) Inventor: LAFOREST, Guy, P-2750 Cascais (PT); MEURY, Marcel, E-43007 Tarragona (ES)
(74) Representative: Shanks, Andrew
(86) International application number: PCT/US1998/023360
(87) International publication number: WO 1999/023708

(56) References cited:
- GB-A- 1 415 003
- US-A- 3 428 408
- US-A- 3 449 637
- US-A- 3 509 388

## Description

### BACKGROUND OF THE INVENTION

### Technical Field

The present invention relates to a piezoelectric ignition mechanism for gas lighters, range tops, outdoor gas grills, or the likes, which comprises a device capable of selectively inhibiting the production of sparks by the piezoelectric ignition mechanism to resist undesired use of the lighter by young children.

### Background Art

Recently, attention has been directed toward preventing ready actuation of cigarette lighters by persons normally not able to appreciate the potential danger of the flame. Such danger includes the potential to burn the individual directly or to burn surrounding areas or items. The individuals contemplated in these efforts are young children in the age category of under five years of age.

As known, piezoelectric mechanisms generally consist of a telescopic assembly comprising an upper member and a lower member, which are capable of moving relative to each other. The outer and inner members are normally kept at a predetermined distance from each other by a return spring. A crystal or piezoelectric element is normally embodied in the upper member of the telescopic assembly. An electrical spark is produced when a hammer or "plexor" impacts the piezoelectric element. The piezoelectric element, in turn, is placed between an "anvil" member, and the "impact pad", which actually receives the impact from the plexor.

The plexor is slideably disposed in the axial void of the telescopic assembly. In the rest position, the plexor is disposed at a predetermined distance away from the impact pad by means of a retaining mechanism. An impact spring is normally positioned between the plexor and the lower telescopic member to bias the plexor toward the impact pad.

To produce a spark, a manual compressive force is applied to the telescopic assembly causing the upper and lower members to move toward each other. This action also compresses the return spring which separates the upper and lower members, and simultaneously compresses the impact spring to store energy therein. Near the end of the contraction of the telescopic assembly, the plexor is released from the retaining mechanism and the compressed impact spring drives the plexor toward the impact pad, creating the impact energy to generate the electrical potential across the piezoelectric element. Said potential is conducted through other conductive elements in the cigarette lighter, which make up an electrical circuit. This circuit has an open gap located near the valve where the fuel from a fuel supply is released. Said potential creates a spark across the gap and ignites the released fuel to create a flame. An example of such piezoelectric mechanism is disclosed in U.S. patent No. 5,262,697 entitled "Piezoelectric Mechanism For Gas Lighters".

It is desirable to increase the difficulty of using lighters to limit the ability of young children under five years of age to operate such piezoelectric lighters. For this reason, there are attempts to provide "child-resistant" piezoelectric lighters offered in the patent literature. Examples of such patents include United States patent Nos: 5,145,358, 5,240,408, 4,904,180, 4,859,172, 4,786,248 and 5,228,849. Each of these disclosed devices has in common the fact that depression of the thumb pad, which compresses the telescopic assembly and activates the piezoelectric mechanism, is prevented by a latch member to inhibit the production of sparks. Normally, the latch member is disposed between the thumb pad and a wall of the lighter body. This latch member must be aligned or positioned precisely between the thumb pad and the wall of the lighter body in order to prevent the depression of the thumb pad.

US-A-3 449 637 discloses a piezoelectric igniter having an elongated housing for carrying a piezoelectric element. A push rod is provided with a spring for biasing a hammer. The hammer is restrained by a latch while the push rod is depressed until the rod releases the latch, permitting the hammer to strike the piezoelectric element. In operation, the push rod is depressed in relation to the housing, compressing the spring and the hammer. The latch retains the hammer relative to the housing while the push rod is moved relatively thereto. Further movement of the push rod releases the latch and the spring biasing the hammer, releasing the hammer which in turn impacts the piezoelectric element to generate a voltage.

US-A-3 509 388 teaches having an operating body that is pushed against a spring while compressing a striker. Further pushing of the operating body in the same direction causes the striker to hit the piezoelectric element to generate a spark. In other words, US-A-3 509 388 teaches pushing or rotating the operating body in one direction in order to displace and cause the piezo unit to generate a spark.

Thus, there remains a need for a device, which increases the difficulty of operating a piezoelectric ignition mechanism and which would not require the precise alignment of the latch member in order to inhibit the production of spark.

### SUMMARY OF THE INVENTION

Thus, it is an object of this invention to provide a lighter which presents a desirable level of difficulty of operation by unintended users.

Another object of the invention is to provide a piezoelectric ignition mechanism which does not require the precise alignment of a latch member between the thumb pad and the lighter body to present a desirable level of difficulty of operation of the ignition mechanism.

Another object of the invention is to provide a lighter having telescopic piezoelectric elements which have no appreciable relative motion with respect to each other unless a latch member is activated.

These and other objectives can be achieved by a piezoelectric ignition mechanism comprising a telescopic assembly having first and second members, a return spring for biasing the second member toward the first member, a piezoelectric element and its impact pad mounted in one of said members, and a plexor member movably disposed within the telescopic assembly and biased toward the piezoelectric element and its impact pad by an impact spring. In a rest configuration, the plexor is positioned in contact with the piezoelectric member and its impact pad such that when an external force is applied to the telescopic assembly both the piezoelectric element and the plexor are displaced together so that the plexor is inhibited from impacting the piezoelectric element and its impact pad.

The piezoelectric ignition mechanism further comprises a latch member actuatable by a user to displace the plexor to a predetermined distance away from the impact pad, so that when the external force, greater than a threshold amount, is applied to the telescopic assembly the plexor strikes the impact pad to excite the piezoelectric element causing it to produce a spark.

### BRIEF DESCRIPTION OF THE DRAWINGS

Fig. 1 is a front longitudinal view of the piezoelectric ignition mechanism according to the present invention in a rest configuration located in a gas lighter assembly;
Fig. 2 is a partial cross sectional view of the piezoelectric ignition mechanism shown in Fig. 1;
Fig. 3 is a front view of an inner telescopic member of the piezoelectric ignition mechanism shown in Fig. 1;
Fig. 4 is a front view of the plexor member;
Fig. 5 is a side view of the plexor member;
Fig. 6 is a front view of an outer telescopic member of the piezoelectric-ignition mechanism show in Fig. 1;
Fig. 7 is a front view of the piezoelectric ignition mechanism in a depressed configuration when the latch is unengaged;
Fig. 8 is a front view of the piezoelectric ignition mechanism similar to that of Fig. 1 but with the latch member engaged;
Fig. 9 is a front view of the piezoelectric mechanism of Fig. 8 in a partially depressed configuration;
Fig. 10 is a front view of the piezoelectric mechanism of Fig. 8 in a fully depressed configuration before the plexor strikes the impact pad;
Fig. 11 is a front view of the piezoelectric mechanism of Fig. 8 in a fully depressed configuration after the plexor strikes the impact pad; and
Fig. 12 is a top view of an alternative embodiment of the latch member.

### DESCRIPTION OF THE PREFERRED EMBODIMENTS

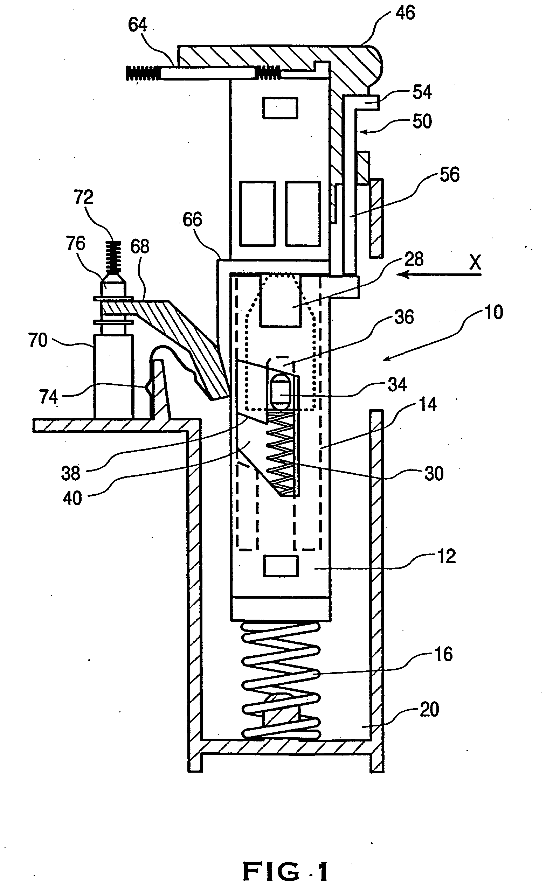

Referring to the drawings, wherein like reference numbers are used to designate like parts, and as shown in Fig. 1, the piezoelectric ignition mechanism 10 of a lighter according to the present invention comprises an outer telescopic member 12, and an inner telescopic member 14. Unlike the telescopic assembly known in the prior art described above, e.g. '697 patent, in the present invention there is substantially little or no separation or space, as denoted by X, between the two telescopic members, in the rest or normal configuration. Return spring 16, which is disposed below outer member 12, resiliently biases the two telescopic members together. Piezoelectric mechanism 10 is disposed in a chamber 20 located on the body of a lighter, and is isolated from the fuel source, e.g., compressed hydrocarbon gas.

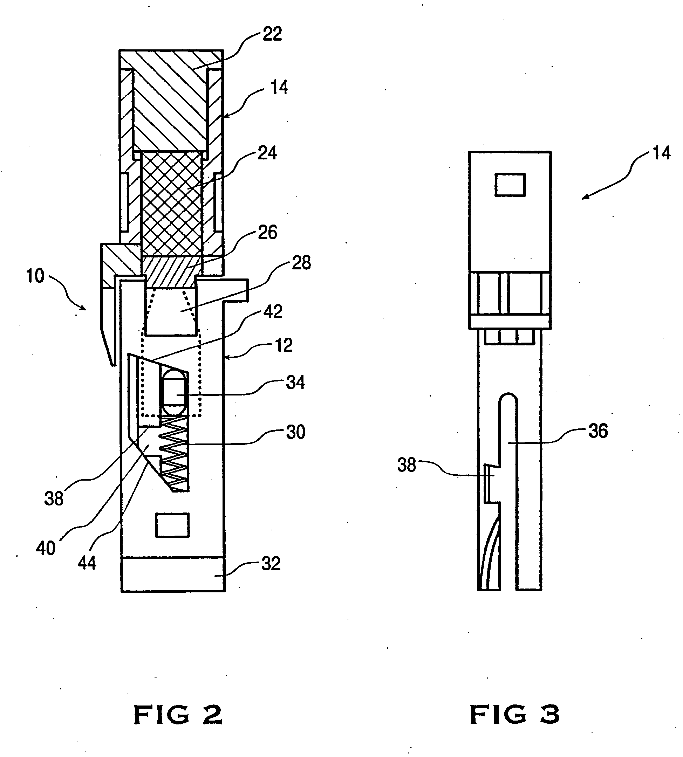

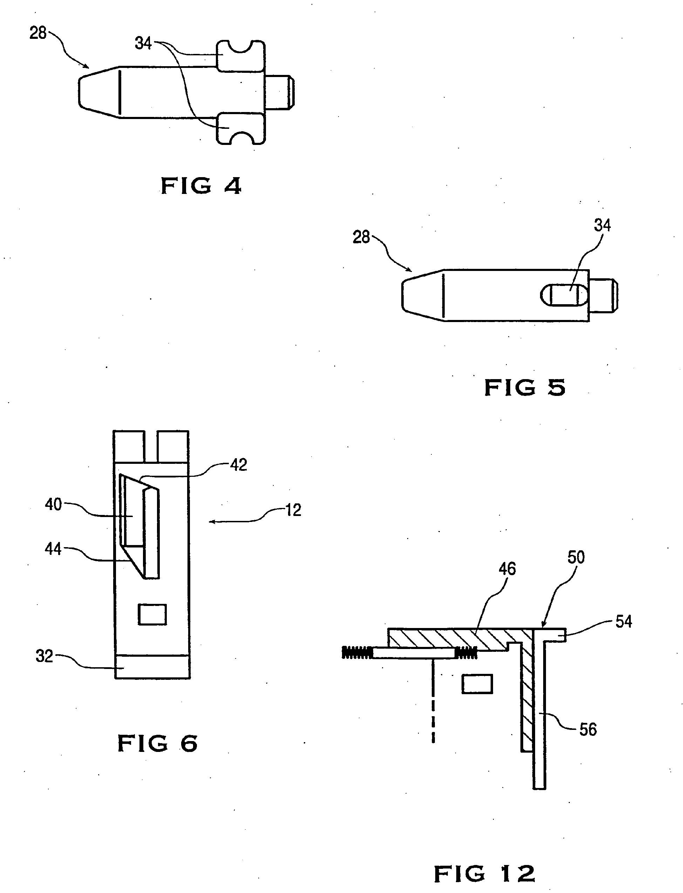

As shown in Fig. 2, piezoelectric mechanism 10 comprises anvil member 22, piezoelectric element 24, and impact pad 26. Plexor member 28, shown in phantom in Fig. 2 and also in Figs. 4 and 5, is guided within inner telescopic member 14 and adjacent to impact pad 26. Plexor 28 is resiliently biased against impact pad 26 by impact spring 30. Spring 30 is also disposed in inner member 14, and is supported on one end by bottom member 32 of outer member 12.

Plexor 28 has two lugs 34 disposed on opposite sides thereof. Lugs 34 are received in longitudinal slots 36, which are defined on opposite sides of inner member 14 as shown in Fig. 3. Longitudinal slots 36 guide the travel of plexor 28, limiting it to the longitudinal direction. Each longitudinal slot 36 also has retaining notch 38, whose functions will be described below. In the rest position shown in Fig. 1, lugs 34 are disposed at or near the upper end of slots 36.

Lugs 34 are configured and dimensioned to protrude beyond slots 36, and into windows 40, which are defined on opposite sides of outer member 12 as shown in Figs. 1, 2 and particularly in Fig. 6. Window 40 also has upper ramp surface 42 and lower ramp surface 44.

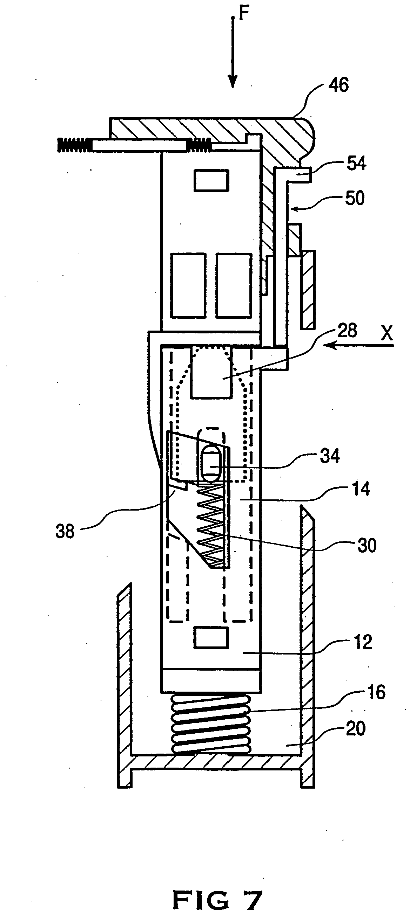

From the rest or normal position, if an external force F is applied to thumb pad 46, both outer and inner telescopic members are simultaneously depressed as depicted in Figs. 1 and 7. Since members 12 and 14 are in contact to each other, there can be no relative movement between members 12 and 14. Return spring 16 is also compressed, so that when force F is released spring 16 resiliently pushes the telescopic assembly upward back to the configuration of Fig. 1. Furthermore, since piezoelectric element 24 and impact pad 26 are embedded in inner telescopic member 14 and plexor is biased against impact pad 26, there is also no relative movement between plexor 28 and impact pad 26, and impact spring 30 is not being compressed. Thus, no impact force between said plexor and impact pad can be generated and no spark is produced. This feature of the present invention allows an unintended user to produce movement from thumb pad 46, but would not allow the unintended user to produce a spark.

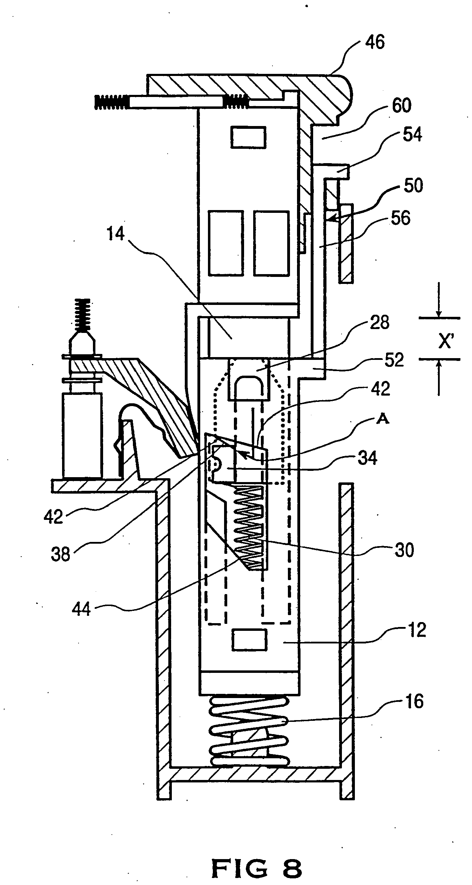

To produce a spark, the intended user first displaces plexor 28 away from impact pad 26 prior to the application of external force F. As shown in Fig. 8, this can be accomplished by manually moving plexor 28 downward and retaining it at a predetermined position away from the piezoelectric element. When latch member 50, which is located near thumb pad 46, is pressed downward, it comes into contact with ledge member 52 of outer telescopic member 12 and pushes member 12 downward, and partially compresses return spring 16 and impact spring 30, as shown in Fig. 8. As outer telescopic member 12 is moved downward, ramp surfaces 42 of windows 40 push lugs 34 downward along longitudinal slots 36. When ramp surfaces 42 align with retaining slots 38, impact spring 30 resiliently pushes lugs 34 along the ramp surfaces 42 and deposits lugs 34 into retaining notches 38, thereby retaining plexor 28 at a position away from impact pad 26. The displacement of lugs 34 is shown by the arrow "A" in Fig. 8. At this point, the top of plexor 28 is located at a predetermined distance X' away from impact pad 26.

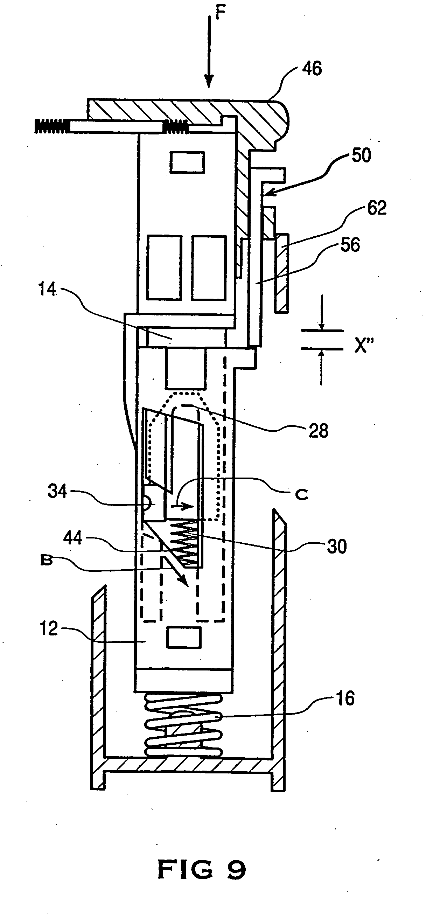

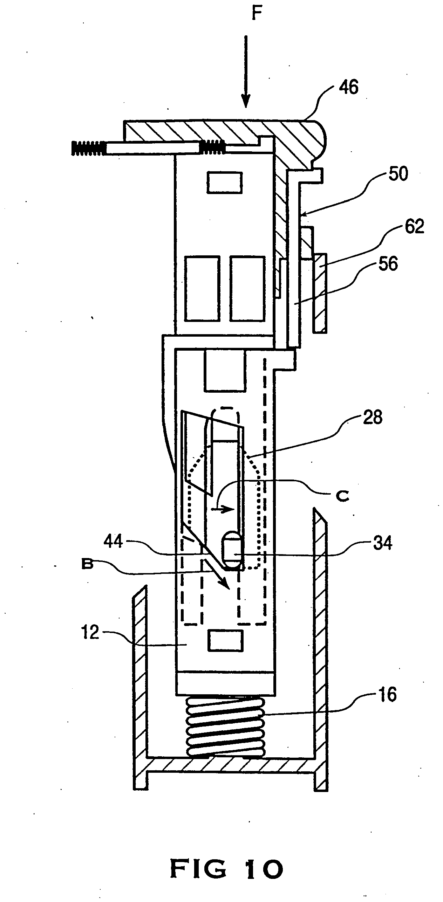

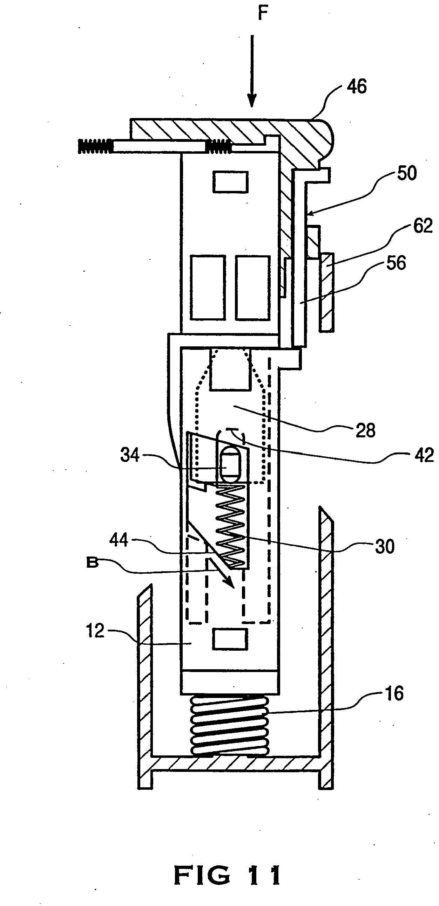

As depicted in Figs. 8 and 9, when piezoelectric mechanism is in this configuration and external force F is applied to thumb pad 46 it pushes inner telescopic member 14 downward. Since there is now separation between members 12 and 14, inner member 14 moves downward into outer member 12, and pushes plexor 28, which is being held in notches 38 of inner member 14, downward and further compresses impact spring 30, until lugs 34 reaches ramp surfaces 44 on windows 40 of outer telescopic member 12. Lugs 34 then ride along ramp surfaces 44 generally in a downward direction as shown by arrow "B" and impact spring 30 is being further compressed as shown in Figs. 9 and 10. As lugs 34 ride down ramps 44, they are displaced from retaining notches 38 and are once again aligned with longitudinal slots 36 as shown by arrow "C", and depicted in Fig. 10. At this point, impact spring 30 is fully compressed. After lugs 34 are free from notches 38, compressed impact spring 30 drives plexor 28 upward along longitudinal slots 36 to strike impact pad 26 and piezoelectric element 24 to produce a spark as shown in Fig. 11. When force F is released, return spring 16 pushes the entire piezoelectric mechanism 10 including latch member 50 upward to the rest configuration shown in Fig. 1.

Latch member 50 may have any configuration as long as it is capable of displacing outer telescopic member 12 away from inner telescopic member 14, and plexor 28 away from impact pad 26. Latch member 50 may be made out of any material, so long as latch member 50 has sufficient stiffness to displace the telescopic members away from each other. An example of latch member 50 is shown in Figs. 1 and 7-9. As shown, latch 50 has a finger actuatable portion 54 and elongated body 56. It is slideably disposed within channel 60, a portion thereof is depicted in Fig. 8, defined in thumb pad 46, and movable up and down in the longitudinal direction. Channel 60 may also be defined in lighter body or the wall of chamber 20. Latch 50 can also be disposed in the space between thumb pad 46 and the outer wall 62 of the lighter body. As stated above, after being displaced downward, latch member 50 is returned to its at rest or normal configuration when return spring 16 returns outer member 12 and thereby ledge member 52 to its rest configuration, after ignition. Another embodiment of latch 50 is shown in Fig. 12, where the top of latch member 50 is positioned near the same level as the top of the thumb pad. Additionally, latch member 50 may also be resiliently biased such that it automatically returns to its at rest position after the plexor is displaced from the impact pad.

Referring to Figs. 1, 2 and 8, after plexor 28 strikes impact pad 26 and piezoelectric element 24, an electrical potential difference is created across piezoelectric element 24. Piezoelectric member 24 is one element in an electrical circuit comprising first electrode 64, anvil 22, piezoelectric member 24, impact pad 26, cam member 66, valve actuator 68, valve system 70 and second electrode 72. Thus, the potential difference across piezoelectric element 24 is conducted through this circuit, and creates substantially the same potential difference between first electrode 64 and second electrode 72. This potential difference is sufficient to discharge a spark across the air gap between the two electrodes. In other words, the two electrodes act similar to a capacitor with air dielectric disposed therebetween. Any electrically conductive material may be utilized to make the components of this circuit. A person of ordinary skill in the art may select suitable materials for the various components in this circuit.

When thumb pad 46 is depressed to create the spark, cam member 66 is also depressed, and acts on valve actuator 68. Actuator 68 is pivoted such that when cam member 66 pushes one end of actuator downward, the other end is moved upward thereby lifting valve system 70 to release fuel gas. The released gas is then ignited by the spark discharged between electrodes 64 and 72.

Valve system 70 controls the release of fuel from the fuel supply. In a preferred embodiment as shown generally in Fig. 1, the fuel supply is compressed gas and valve system 70 is a normally open valve, forced closed by the pressure of a spring member 74. In this embodiment, valve actuator 68 acts on valve system 70 to lift valve stem 76 upward to release the compressed hydrocarbon gas.

In another embodiment, a normally closed valve, forced closed by an internal spring can be used with a valve actuator which exerts an upward pressure on valve system 70 to open the valve.

To operate the lighter, the user first depresses latch member 50 to separate telescopic member 14 from telescopic member 12, and simultaneously displace plexor 28 away from piezoelectric member 24 and impact pad 26. The user then depresses thumb pad 46, which causes cam member 66 to engage valve actuator 68 to lift valve stem 76 to release fuel gas. The depression of thumb pad 46 also causes plexor 28 to be released from the retaining mechanism thereby allowing compressed spring 30 to drive plexor 28 against impact pad 26 and causing piezoelectric element 24 to produce a spark to ignite the released fuel to produce a flame. To extinguish the flame, the user simply releases thumb pad 46 thereby releasing valve actuator 68 allowing spring 74 to close valve system 70. Spring 16 returns the piezoelectric ignition mechanism 10 to its rest or normal configuration as shown in Fig. 11.

The piezoelectric ignition mechanism of the present invention may also used with a natural gas oven range, an outdoor gas grill or similar devices to discourage undesirable usage.

While various descriptions of the present invention were described above, this invention is not to be limited to only the specifically preferred embodiments depicted therein.

## Claims

1. A piezoelectric ignition mechanism (10) comprising:
a telescopic assembly having first and second members (14, 12) actuatable by a push button (46),
a piezoelectric element (24) mounted in one of said members (14, 12), and
a plexor member (28) movably disposed within the telescopic assembly, and biased toward the piezoelectric element (24) by an impact spring (30);
**characterised by**
a return spring (16) for biasing the second member (12) toward the first member (14); in that
in a rest configuration the plexor member (28) is positioned in contact with the piezoelectric element (24) such that when an external force is applied to the push button (46) to compress the telescopic assembly both the piezoelectric element (24) and the plexor member (28) are displaced together so that the plexor member (28) is inhibited from impacting the piezoelectric element (24) and in that
the piezoelectric ignition mechanism (10) further comprises a latch member (50) actuatable by a user to displace the plexor member (28) to a predetermined distance away from the piezoelectric element (24), so that when the external force is subsequently applied to the push button (46) to compress the telescopic assembly the plexor member (28) impacts the piezoelectric element (24) to produce a spark.

2. The piezoelectric ignition mechanism (10) according to claim 1 further comprises a retaining mechanism (38), so that when the plexor member (28) is displaced to said predetermined distance, it is retained by said retaining mechanism (38).

3. The piezoelectric ignition mechanism (10) according to claim 2 wherein the piezoelectric element (24) is disposed in the first member (14) of the telescopic assembly, and wherein the plexor member (28) comprises at least one lug (34) disposed on its side, said at least one lug (34) is received by at least one longitudinal slot (36) defined on the first member (14), so that the movement of the plexor member (28) is guided by said at least one longitudinal slot (36).

4. The piezoelectric ignition mechanism (10) according to claim 3 wherein the retaining mechanism (38) comprises at least one notch (38) defined on the first member (14), such that when the at least one lug (34) is received in the at least one notch (38) the plexor member (28) is positioned at said predetermined distance from the piezoelectric element (24).

5. The piezoelectric ignition mechanism (10) according to claim 4 wherein when the latch (50) is actuated, the second member (12) is also displaced from the first member (14).

6. The piezoelectric ignition mechanism (10) according to claim 5 wherein the second member (12) defines at least one first ramp (42) so that when the second member (12) is displaced, it displaces the plexor member (28) until the at least one first ramp (42) aligns with the at least one notch (38) so that the at least one lug (34) is guided by the first ramp into the at least one notch (38).

7. The piezoelectric ignition mechanism (10) according to claim 6 wherein the applied force moves the first member (14) toward the second member (12).

8. The piezoelectric ignition mechanism (10) according to claim 7 wherein the second member (12) defines at least one second ramp (44), so that when the first member (14) is moved toward the second member (12), the at least one lug (34) rides on the second ramp (44) until the plexor member (28) is released from the at least one notch (38).

9. A piezoelectric ignition mechanism (10) according to claim 8 further comprises an impact pad (26) disposed between the piezoelectric element (24) and the plexor (28).

10. The piezoelectric ignition mechanism (10) according to 9 further comprises an anvil member (22) and two electrodes (64, 72), said electrodes (64, 72) defining a gap therebetween, such that the spark generated by the impact between the plexor (28) and the piezoelectric element (24) is conducted to the electrodes (64, 72) and discharged from one electrode to the other.

11. A piezoelectric ignition mechanism (10) according to claim 1 wherein the latch member (50) is received in a channel (60) defined in a push-button (46) where the external force is applied.

12. A lighter comprising:
a lighter body containing a fuel reservoir with a valve (70) for releasing fuel therefrom;
a valve actuator (68) depressible to actuate said valve (70) to release said fuel; and
a piezoelectric ignition mechanism (10) according to claim 1.

13. The lighter according to claim 12 further comprising a retaining mechanism (38) so that when the plexor member (28) is displaced to said predetermined distance, it is retained by said retaining mechanism (38)

14. The lighter according to claim 13 wherein the piezoelectric element (24) is disposed in the first member (14) of the telescopic assembly, and wherein the plexor member (28) comprises at least one lug (34) disposed on its side, said at least one lug (34) is received by at least one longitudinal slot (36) defined on the first member (14), so that the movement of the plexor member (28) is guided by said at least one longitudinal slot (36).

15. The lighter according to claim 14 wherein the retaining mechanism comprises at least one notch (38) defined on the first member (14), such that when the at least one lug (34) is received in the at least one notch (38) the plexor member (28) is positioned at said predetermined distance from the piezoelectric element (24).

16. The lighter according to claim 15 wherein when the latch (50) is actuated the second member (12) is also displaced from the first member (14), and wherein the second member (12) defines at least one first ramp (42) so that when the second member (12) is displaced, it displaces the plexor member (28) until the at least one first ramp (42) aligns with the at least one notch (38) so that the at least one lug (34) is guided by the first ramp (42) into the at least one notch (38).

17. The lighter according to claim 16 wherein the applied force moves the first member (14) toward the second member (12).

18. The lighter according to claim 17 wherein the second member (12) defines at least one second ramp (44), so that when the first member (14) is moved toward the second member (12), the at least one lug (34) rides on the second ramp (44) until the plexor member (28) is released from the at least one notch (38).

19. The lighter according to claim 18 further comprises an impact pad (26) disposed between the piezoelectric element (24) and the plexor member (28).

20. The according to claim 19 further comprises an anvil member (22)and two electrodes (64, 72), said electrodes (64, 72) defining a gap therebetween, such that the spark generated by the impact between the plexor member (28) and the piezoelectric element (24) is conducted to the electrodes (64, 72) and discharged from one electrode to the other.

21. The lighter according to claim 12 wherein the latch member (50) is received in a channel (60) defined in a push-button (46) where the external force is applied.

22. The lighter according to claim 12 wherein the latch member (50) is received in a channel defined in the lighter body.

23. The lighter according to claim 12 wherein the latch member (50) returns to the rest configuration after the spark is produced.

## Patentansprüche

1. Piezoelektrischer Zündmechanismus (10), der aufweist:
eine teleskopische Baugruppe mit einem ersten und zweiten Teil (14, 12), die mittels eines Druckknopfes (46) betätigt werden können;
ein piezoelektrisches Element (24), das auf einem der Teile (14, 12) montiert ist; und
ein Plexorteil (Hammer) (28), das innerhalb der teleskopischen Baugruppe beweglich angeordnet ist und in Richtung des piezoelektrischen Elementes (24) mittels einer Aufprallfeder (30) vorgespannt wird;
**gekennzeichnet durch**
eine Rückstellfeder (16) für das Vorspannen des zweiten Teils (12) in Richtung des ersten Teils (14); **dadurch**, dass in einer Ruhekonfiguration das Plexorteil (28) in Kontakt mit dem piezoelektrischen Element (24) positioniert wird, so dass, wenn eine äußere Kraft auf den Druckknopf (46) angewandt wird, um die teleskopische Baugruppe zusammenzudrücken, sowohl das piezoelektrische Element (24) als auch das Plexorteil (28) zusammen so verschoben werden, dass das Plexorteil (28) daran gehindert wird, auf das piezoelektrische Element (24) aufzutreffen; und **dadurch**, dass
der piezoelektrische Zündmechanismus (10) außerdem ein Einklinkteil (50) aufweist, das von einem Benutzer betätigt werden kann, um das Plexorteil (28) über einen vorgegebenen Abstand weg vom piezoelektrischen Element (24) zu verschieben, so dass, wenn die äußere Kraft nachfolgend auf den Druckknopf (46) angewandt wird, um die teleskopische Baugruppe zusammenzudrücken, das Plexorteil (28) auf das piezoelektrische Element (24) auftrifft, um einen Funken zu erzeugen.

2. Piezoelektrischer Zündmechanismus (10) nach Anspruch 1, der außerdem einen Haltemechanismus (38) aufweist, so dass, wenn das Plexorteil (28) um den vorgegebenen Abstand verschoben wird, es mittels des Haltemechanismus (38) festgehalten wird.

3. Piezoelektrischer Zündmechanismus (10) nach Anspruch 2, bei dem das piezoelektrische Element (24) im ersten Teil (14) der teleskopischen Baugruppe angeordnet wird, und bei dem das Plexorteil (28) mindestens einen Ansatz (34) aufweist, der auf seiner Seite angeordnet ist, wobei der mindestens eine Ansatz (34) durch den mindestens einen Längsschlitz (36) aufgenommen wird, der im ersten Teil (14) definiert wird, so dass die Bewegung des Plexorteils (28) durch den mindestens einen Längsschlitz (36) geführt wird.

4. Piezoelektrischer Zündmechanismus (10) nach Anspruch 3, bei dem der Haltemechanismus (38) mindestens eine im ersten Teil (14) definierte Kerbe (38) aufweist, so dass, wenn der mindestens eine Ansatz (34) in der mindestens einen Kerbe (38) aufgenommen wird, das Plexorteil (28) mit dem vorgegebenen Abstand vom piezoelektrischen Element (24) positioniert wird.

5. Piezoelektrischer Zündmechanismus (10) nach Anspruch 4, bei dem, wenn die Klinke (50) betätigt wird, das zweite Teil (12) ebenfalls vom ersten Teil (14) verschoben wird.

6. Piezoelektrischer Zündmechanismus (10) nach Anspruch 5, bei dem das zweite Teil (12) mindestens eine erste Abschrägung (42) definiert, so dass, wenn das zweite Teil (12) verschoben wird, es das Plexorteil (28) verschiebt, bis sich die mindestens eine erste Abschrägung (42) mit der mindestens einen Kerbe (38) ausrichtet, so dass der mindestens eine Ansatz (34) durch die erste Abschrägung in die mindestens eine Kerbe (38) geführt wird.

7. Piezoelektrischer Zündmechanismus (10) nach Anspruch 6, bei dem die angewandte Kraft das erste Teil (14) in Richtung des zweiten Teils (12) bewegt.

8. Piezoelektrischer Zündmechanismus (10) nach Anspruch 7, bei dem das zweite Teil (12) mindestens eine zweite Abschrägung (44) definiert, so dass, wenn das erste Teil (14) in Richtung des zweiten Teils (12) bewegt wird, sich der mindestens eine Ansatz (34) auf der zweiten Abschrägung (44) bewegt, bis das Plexorteil (28) aus der mindestens einen Kerbe (38) freigegeben wird.

9. Piezoelektrischer Zündmechanismus (10) nach Anspruch 8, der außerdem einen Stoßdämpfer (26) aufweist, der zwischen dem piezoelektrischen Element (24) und dem Plexor (28) angeordnet ist.

10. Piezoelektrischer Zündmechanismus (10) nach Anspruch 9, der außerdem ein Ambossteil (22) und zwei Elektroden (64, 72) aufweist, wobei die Elektroden (64, 72) einen Spalt dazwischen definieren, so dass der durch den Schlag zwischen dem Plexor (28) und dem piezoelektrischen Element (24) erzeugte Funke zu den Elektroden (64, 72) geleitet und von einer Elektrode zur anderen entladen wird.

11. Piezoelektrischer Zündmechanismus (10) nach Anspruch 1, bei dem das Einklinkteil (50) in einem Kanal (60) aufgenommen wird, der in einem Druckknopf (46) definiert wird, wo die äußere Kraft angewandt wird.

12. Anzünder, der aufweist:
ein Anzündergehäuse, das einen Brennstoffvorratsbehälter mit einem Ventil (70) für das Freigeben von Brennstoff daraus enthält;
ein Ventilbetätigungselement (68), das niedergedrückt werden kann, um das Ventil (70) zu betätigen, damit der Brennstoff freigegeben wird; und
einen piezoelektrischen Zündmechanismus (10) nach Anspruch 1.

13. Anzünder nach Anspruch 12, der außerdem einen Haltemechanismus (38) aufweist, so dass, wenn das Plexorteil (28) um den vorgegebenen Abstand verschoben wird, es mittels des Haltemechanismus (38) festgehalten wird.

14. Anzünder nach Anspruch 13, bei dem das piezoelektrische Element (24) im ersten Teil (14) der teleskopischen Baugruppe angeordnet wird, und bei dem das Plexorteil (28) mindestens einen Ansatz (34) aufweist, der auf seiner Seite angeordnet ist, wobei der mindestens eine Ansatz (34) durch mindestens einen Längsschlitz (36) aufgenommen wird, der im ersten Teil (14) definiert wird, so dass die Bewegung des Plexorteils (28) durch den mindestens einen Längsschlitz (36) geführt wird.

15. Anzünder nach Anspruch 14, bei dem der Haltemechanismus mindestens eine im ersten Teil (14) definierte Kerbe (38) aufweist, so dass, wenn der mindestens eine Ansatz (34) in der mindestens einen Kerbe (38) aufgenommen wird, das Plexorteil (28) mit dem vorgegebenen Abstand vom piezoelektrischen Element (24) positioniert wird.

16. Anzünder nach Anspruch 15, bei dem, wenn die Klinke (50) betätigt wird, das zweite Teil (12) ebenfalls vom ersten Teil (14) verschoben wird, und bei dem das zweite Teil (12) mindestens eine erste Abschrägung (42) definiert, so dass, wenn das zweite Teil (12) verschoben wird, es das Plexorteil (28) verschiebt, bis sich die mindestens eine erste Abschrägung (42) mit der mindestens einen Kerbe (38) ausrichtet, so dass der mindestens eine Ansatz (34) durch die erste Abschrägung (42) in die mindestens eine Kerbe (38) geführt wird.

17. Anzünder nach Anspruch 16, bei dem die angewandte Kraft das erste Teil (14) in Richtung des zweiten Teils (12) bewegt.

18. Anzünder nach Anspruch 7, bei dem das zweite Teil (12) mindestens eine zweite Abschrägung (44) definiert, so dass, wenn das erste Teil (14) in Richtung des zweiten Teils (12) bewegt wird, sich der mindestens eine Ansatz (34) auf der zweiten Abschrägung (44) bewegt, bis das Plexorteil (28) aus der mindestens einen Kerbe (38) freigegeben wird.

19. Anzünder nach Anspruch 18, der außerdem einen Stoßdämpfer (26) aufweist, der zwischen dem piezoelektrischen Element (24) und dem Plexorteil (28) angeordnet ist.

20. Anzünder nach Anspruch 19, der außerdem ein Ambossteil (22) und zwei Elektroden (64, 72) aufweist, wobei die Elektroden (64, 72) einen Spalt dazwischen definieren, so dass der durch den Schlag zwischen dem Plexorteil (28) und dem piezoelektrischen Element (24) erzeugte Funke zu den Elektroden (64, 72) geleitet und von einer Elektrode zur anderen entladen wird.

21. Anzünder nach Anspruch 12, bei dem das Einklinkteil (50) in einem Kanal (60) aufgenommen wird, der in einem Druckknopf (46) definiert wird, wo die äußere Kraft angewandt wird.

22. Anzünder nach Anspruch 12, bei dem das Einklinkteil (50) in einem Kanal aufgenommen wird, der im Anzündergehäuse definiert wird.

23. Anzünder nach Anspruch 12, bei dem das Einklinkteil (50) in die Ruhekonfiguration zurückkehrt, nachdem der Funke erzeugt wurde.

## Revendications

1. Mécanisme d'allumage piézoélectrique (10), comprenant :
un assemblage télescopique, comportant des premier et deuxième éléments (13, 12) pouvant être actionnés par un bouton-poussoir (46) ;
un élément piézoélectrique (24), monté dans l'un desdits éléments (14, 12) ; et
un élément plexor (28), agencé de manière mobile dans l'assemblage télescopique et poussé vers l'élément piézoélectrique (24) par un ressort à impact (30) ; **caractérisé par**
un ressort de rappel (16), pour pousser le deuxième élément (12) vers le premier élément (14) ; et en ce que
dans une configuration de repos, l'élément plexor (28) est positionné en contact avec l'élément piézoélectrique (24), de sorte que lors de l'application d'une force externe au bouton-poussoir (46) pour comprimer l'assemblage télescopique, l'élément piézoélectrique (24) et l'élément plexor (28) sont déplacés ensemble, un impact de l'élément plexor (28) contre l'élément piézoélectrique (24) étant ainsi empêché ; et en ce que
le mécanisme d'allumage piézoélectrique (10) comprend en outre un élément de verrou (50), pouvant être actionné par un utilisateur pour déplacer l'élément plexor (28) sur une distance prédéterminée à l'écart de l'élément piézoélectrique (24), de sorte que l'application ultérieure d'une force externe au bouton-poussoir (46) pour comprimer l'assemblage télescopique entraîne l'impact de l'élément plexor (28) contre l'élément piézoélectrique (24) pour produire une étincelle.

2. Mécanisme d'allumage piézoélectrique (10) selon la revendication 1, comprenant en outre un mécanisme de retenue (38), de sorte que lorsque l'élément plexor (28) est déplacé sur ladite distance prédéterminée, il est retenu par ledit mécanisme de retenue (38).

3. Mécanisme d'allumage piézoélectrique (10) selon la revendication 2, dans lequel l'élément piézoélectrique (24) est agencé dans le premier élément (14) de l'assemblage télescopique, l'élément plexor (28) comprenant au moins une patte (34) agencée sur son côté, ladite au moins une patte (34) étant reçue par au moins une fente longitudinale (36) définie sur le premier élément, de sorte que le déplacement de l'élément plexor (28) est guidé par ladite au moins une fente longitudinale (36).

4. Mécanisme d'allumage piézoélectrique (10) selon la revendication 3, dans lequel le mécanisme de retenue (38) comprend au moins une encoche (38), définie sur le premier élément (14), de sorte que lorsque la au moins une patte (34) est reçue dans la au moins une encoche (38), l'élément plexor (28) est positionné à ladite distance prédéterminée de l'élément piézoélectrique (24).

5. Mécanisme d'allumage piézoélectrique (10) selon la revendication 4, dans lequel, lors de l'actionnement du verrou (50), le deuxième élément (12) est également déplacé par rapport au premier élément (14).

6. Mécanisme d'allumage piézoélectrique (10) selon la revendication 5, dans lequel le deuxième élément (12) définit au moins une première rampe (42), de sorte que lorsque le deuxième élément (12) est déplacé, il déplace l'élément plexor (28) jusqu'à l'alignement de la au moins une première rampe (42) avec la au moins une encoche (38), la au moins une patte (34) étant ainsi guidée par la première rampe dans la au moins une encoche (38).

7. Mécanisme d'allumage piézoélectrique (10) selon la revendication 6, dans lequel la force appliquée déplace le premier élément (14) vers le deuxième élément (12).

8. Mécanisme d'allumage piézoélectrique (10) selon la revendication 7, dans lequel le deuxième élément (12) définit au moins une deuxième rampe (44), de sorte que lorsque le premier élément (14) est déplacé vers le deuxième élément (12), la au moins une patte (34) se déplace sur la deuxième rampe (44) jusqu'au dégagement de l'élément plexor (28) de la au moins une encoche (38).

9. Mécanisme d'allumage piézoélectrique (10) selon la revendication 8, comprenant en outre un patin d'impact (26) agencé entre l'élément piézoélectrique (24) et l'élément plexor (28).

10. Mécanisme d'allumage piézoélectrique (10) selon la revendication 9, comprenant en outre un élément d'enclume (22) et deux électrodes (64, 72), lesdites électrodes (64, 72) définissant un espace entre elles, de sorte que l'étincelle produite par l'impact entre l'élément plexor (28) et l'élément piézoélectrique (24) est conduite vers les électrodes (64, 72) et est déchargée d'une électrode vers l'autre.

11. Mécanisme d'allumage piézoélectrique (10) selon la revendication 1, dans lequel l'élément de verrou (50) est reçu dans un canal (60) défini dans le bouton poussoir (46), au niveau duquel la force externe est appliquée.

12. Briquet, comprenant :
un corps de briquet, contenant un réservoir de combustible avec une soupape (70) pour libérer du combustible à partir de celui-ci ;
un élément d'actionnement de soupape (68), pouvant être enfoncé pour actionner ladite soupape (70) afin de libérer ledit combustible ; et
un mécanisme d'allumage piézoélectrique (10) selon la revendication 1.

13. Briquet selon la revendication 12, comprenant en outre un mécanise de retenue (38), de sorte que lorsque l'élément plexor (28) est déplacé sur ladite distance prédéterminée, il est retenu par ledit mécanisme de retenue (3 8).

14. Briquet selon la revendication 13, dans lequel l'élément piézoélectrique (24) est agencé dans le premier élément (14) de l'assemblage télescopique, l'élément plexor (28) comprenant au moins une patte (34) agencée sur son côté, ladite au moins une patte (34) étant reçue par au moins une fente longitudinale (36) définie sur le premier élément (14), de sorte que le déplacement de l'élément plexor (28) est guidé par ladite au moins une fente longitudinale (36).

15. Briquet selon la revendication 14, dans lequel le mécanisme de retenue comprend au moins une encoche (38) définie sur le premier élément (14), de sorte que lorsque la au moins une patte (34) est reçue dans la au moins une encoche (38), l'élément plexor (28) est positionné à ladite distance prédéterminée de l'élément piézoélectrique (24).

16. Briquet selon la revendication 15, dans lequel, lors de l'actionnement du verrou (50), le deuxième élément (12) est également déplacé par rapport au premier élément (14), le deuxième élément (12) définissant au moins une première rampe (42), de sorte que lorsque le deuxième élément (12) est déplacé, il déplace l'élément plexor (28) jusqu'à l'alignement de la au moins une première rampe (42) avec la au moins une encoche (38), la au moins une patte (34) étant ainsi guidée par la première rampe (42) dans la au moins une encoche (38).

17. Briquet selon la revendication 16, dans lequel la force appliquée déplace le premier élément (14) vers le deuxième élément (12).

18. Briquet selon la revendication 17, dans lequel le deuxième élément (12) définit au moins une deuxième rampe (44), de sorte que lorsque le premier élément (14) est déplacé vers le deuxième élément (12), la au moins une patte (34) se déplace sur la deuxième rampe (44) jusqu'au dégagement de l'élément plexor (28) de la au moins une encoche (38).

19. Briquet selon la revendication 18, comprenant en outre un patin d'impact (26) agencé entre l'élément piézoélectrique (24) et l'élément plexor (28).

20. Briquet selon la revendication 19, comprenant en outre un élément d'enclume (22) et deux électrodes (64, 72), lesdites électrodes (64, 72) définissant un espace entre elles, de sorte que l'étincelle produite par l'impact entre l'élément plexor (28) et l'élément piézoélectrique (24) est conduite vers les électrodes (64, 72) et est déchargée d'une électrode vers l'autre.

21. Briquet selon la revendication 12, dans lequel l'élément de verrou (50) est reçu dans un canal (60) défini dans un bouton-poussoir (46), au niveau duquel la force externe est appliquée.

22. Briquet selon la revendication 12, dans lequel l'élément de verrou (50) est reçu dans un canal défini dans le corps du briquet.

23. Briquet selon la revendication 12, dans lequel l'élément de verrou (50) retourne vers la configuration de repos après la production de l'étincelle.
